# EUROPEAN PATENT APPLICATION

(11) **EP 3 700 305 A1**
(43) Date of publication of application: **26.08.2020**
(21) Application number: 18868006.0
(22) Date of filing: 17.10.2018
(51) Int. Cl.: H05B 33/14, H01L 51/50, H05B 33/02

(54) **LIGHT EMITTING ELEMENT AND ILLUMINATING APPARATUS**

(30) Priority: 19.10.2017 JP 2017202874
(71) Applicant: NS Materials Inc., Chikushino City, Fukuoka 818-0042 (JP)
(72) Inventor: MIYANAGA, Akiharu, Chikushino-city Fukuoka 818-0042 (JP); ITO, Tetsuji, Chikushino-city Fukuoka 818-0042 (JP); WATANABE, Mayuko, Chikushino-city Fukuoka 818-0042 (JP)
(74) Representative: SSM Sandmair
(86) International application number: PCT/JP2018/038618
(87) International publication number: WO 2019/078235

(57) **Abstract**

Provided is a light emitting device and an illumination device that include quantum dots. A light emitting device (1) includes an anode (3), a hole transport layer (4), an emitting layer (5), an electron transport layer (6), and a cathode (7). The light emitting layer is formed of an inorganic layer containing quantum dots. All the layers from the anode to the cathode are preferably each formed of the inorganic layer. The hole transport layer, the emitting layer, and the electron transport layer are preferably each constituted by the inorganic layer formed from nanoparticles.

## Description

### TECHNICAL FIELD

The present invention relates to a light emitting device and an illumination device using quantum dots.

### BACKGROUND ART

JP 2017-045650 A (PTL 1) discloses an invention relating to organic electroluminescence (EL).

An organic EL device has a structure in which, an anode, a hole injection layer, a hole transport layer, an emitting layer, an electron transport layer, an electron injection layer, and a cathode are stacked on a substrate. Such an organic EL device is formed from an organic compound and emits light from excitons formed by the recombination of electrons and holes injected into the organic compound.

### CITATION LIST

### Patent Literature

PTL 1: JP 2017-045650 A

### SUMMARY OF INVENTION

### (Technical Problem)

In recent years, light emitting devices using quantum dots are being developed. Quantum dots are nanoparticles made of around several hundreds to several thousands of atoms, each having a particle diameter of around several nanometers to several tens of nanometers. Quantum dots are also referred to as fluorescent nanoparticles, semiconductor nanoparticles, or nanocrystals. The emission wavelength of quantum dots may be variously changed depending on the particle diameter and the composition of the nanoparticles.

However, the layered structure of light emitting devices using quantum dots has not yet been established.

The present invention is made in consideration of the above, and seeks to provide a light emitting device and an illumination device that include quantum dots.

### (Solution to Problem)

In an aspect of the present invention, a light emitting device includes an anode, an emitting layer, a cathode, a layer between the anode and the emitting layer, and a layer between the cathode and the emitting layer that are stacked. The emitting layer is formed of an inorganic layer containing quantum dots.

In an aspect of the present invention, all the layers from the anode to the cathode are preferably each formed of the inorganic layer.

In an aspect of the present invention, the layer between the anode and the emitting layer, the emitting layer, and the layer between the cathode and the emitting layer are preferably each constituted by the inorganic layer formed from nanoparticles.

In an aspect of the present invention, the light emitting device is preferably flexible.

In an aspect of the present invention, the quantum dots preferably have a structure in which a surface of a core is not covered by a shell.

In an aspect of the present invention, the anode, the layer between the anode and the emitting layer, the emitting layer, the layer between the cathode and the emitting layer, and the cathode may be stacked in this order on a substrate.

In an aspect of the present invention, the cathode, the layer between the cathode and the emitting layer, the emitting layer, the layer between the anode and the emitting layer, and the anode may be stacked in this order on a substrate.

Further, an illumination device according to an aspect of the present invention uses one of the light emitting devices described above.

### (Advantageous Effects of Invention)

In a light emitting device of the present invention, all the layers from the anode to the cathode can be formed of inorganic layers. This renders the hole injection layer and the electron injection layer unnecessary, simplifies the layer structure as compared with a conventional structure, and facilitates the production of the light emitting device.

### BRIEF DESCRIPTION OF THE DRAWINGS

In the accompanying drawings:
FIG. 1A is a cross-sectional view of a light emitting device according to Embodiment 1;
FIG. 1B presents an energy level diagram of each layer in the light emitting device in Embodiment 1;
FIG. 2A is a schematic view of a quantum dot according to this embodiment;
FIG. 2B is a schematic view of a quantum dot according to this embodiment;
FIG. 3A is a cross-sectional view of a light emitting device according to Embodiment 2;
FIG. 3B presents an energy level diagram of each layer in the light emitting device in Embodiment 2;
FIG. 4 is a cross-sectional view illustrating an example of a practical structure of an illumination device using the light emitting device of this embodiment;
FIG. 5 is a schematic view illustrating a back light unit as an illumination device of this embodiment;
FIG. 6 is a schematic view illustrating a light source device as an illumination device of this embodiment;
FIG. 7 is a schematic view of an electric light bulb as an illumination device of this embodiment;
FIG. 8A presents an energy level in the case of using quantum dots having a core-shell structure;
FIG. 8B presents an energy level in the case of using quantum dots having a structure in which a core is not covered by a shell;
FIG. 9 is a cross-sectional view illustrating an example of the layered structure of a light emitting device emitting white light;
FIG. 10 is a cross-sectional view illustrating an example of a layered structure of a light emitting device emitting white light; and
FIG. 11 is a photograph showing an application in Example.

### DESCRIPTION OF EMBODIMENTS

Embodiments of the present invention (hereinafter simply referred to as "embodiments") will now be described in detail. Note that the present invention is not limited to the following embodiments, and various modifications may be made without departing from the spirit of the present invention.

Hereinafter, "light emitting devices" will be described. Conceptually, a light emitting device may be an illumination device itself; alternatively, an illumination device may be constructed to include a light emitting device.

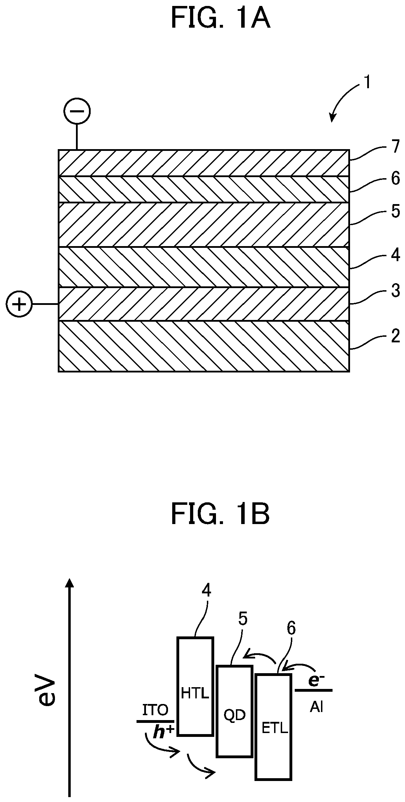

FIG. 1A is a cross-sectional view of a light emitting device of Embodiment 1, and FIG. 1B is an energy level diagram of the light emitting device of Embodiment 1.

As shown in FIG. 1A, a light emitting device 1 is constructed to have a substrate 2, an anode 3 formed on the substrate, a hole transport layer (HTL) 4 formed on the anode 3, an emitting layer (EML) 5 formed on the hole transport layer 4, an electron transport layer (ETL) 6 formed on the emitting layer 5, and a cathode 7 formed on the electron transport layer 6.

When a voltage is applied to such a light emitting device 1, holes are injected from the anode 3, and electrons are injected from the cathode 7. FIG. 1B shows the energy level model of each of the hole transport layer 4, the emitting layer 5, and the electron transport layer 6. As shown in FIG. 1B, holes transported by the hole transport layer 4 are injected from the HOMO level of the hole transport layer 4 into the HOMO level of the emitting layer 5. On the other hand, electrons transported by the electron transport layer 6 are injected from the LUMO level of the electron transport layer 6 into the LUMO level of the emitting layer 5. The holes and electrons are recombined in the emitting layer 5, which promotes quantum dots in the emitting layer 5 to the excited state, thus light emission from the excited quantum dots can be achieved.

In this embodiment, the emitting layer 5 is an inorganic layer containing quantum dots. Further, in this embodiment, all the layers from the anode 3 to the cathode 7 are preferably each formed of an inorganic layer. Namely, all the anode 3, the hole transport layer 4, the emitting layer 5, the electron transport layer 6, and the cathode 7 are preferably each formed of an inorganic layer.

### (Quantum dot)

For example, quantum dots in this embodiment are nanoparticles having a particle diameter of around several nanometers to several tens of nanometers; however, the structure and the material of the quantum dots are not limited to those.

For example, quantum dots are formed from CdS, CdSe, ZnS, ZnSe, ZnSeS, ZnTe, ZnTeS, InP, AgInS₂, CuInS₂, etc. Because of the toxicity of Cd, the use of Cd is restricted in many countries; thus, quantum dots are preferably free of Cd.

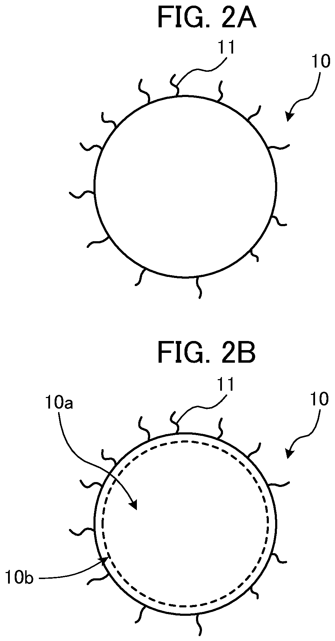

As shown in FIG. 2, many organic ligands 11 are preferably placed on the surface of a quantum dot 10. This can inhibit aggregation of quantum dots 10, resulting in the target optical properties. The ligands available for the reaction are not particularly limited; for example, the following ligands can be given as typical examples.
Aliphatic primary amines: oleylamine: C₁₈H₃₅NH₂, stearyl(octadecyl)amine: C₁₈H₃₇NH₂, dodecyl(lauryl)amine: C₁₂H₂₅NH₂, decylamine: C₁₀H₂₁NH₂, octylamine: C₈H₁₇NH₂ Aliphatic acids: oleic acid: C₁₇H₃₃COOH, stearic acid: C₁₇H₃₅COOH, palmitic acid: C₁₅H₃₁COOH, myristic acid: C₁₃H₂₇COOH, lauric (dodecanoic) acid: C₁₁H₂₃COOH, decanoic acid: C₉H₁₉COOH, octanoic acid: C₇H₁₅COOH
Thiols: octadecanethiol: C₁₈H₃₇SH, hexadecanethiol: C₁₆H₃₃SH, tetradecanethiol: C₁₄H₂₉SH, dodecanethiol: C₁₂H₂₅SH, decanethiol: C₁₀H₂₁SH, octanethiol: C₈H₁₇SH Phosphines: trioctylphosphine: (C₈H₁₇)₃P, triphenylphosphine: (C₆H₅)₃P, tributylphosphine: (C₄H₉)₃P
Phosphine oxides: trioctylphosphine oxide: (C₈H₁₇)₃P=O, triphenylphosphine oxide: (C₆H₅)₃P=O, tributylphosphine oxide: (C₄H₉)₃P=O

A quantum dot 10 depicted in FIG. 2B has a core-shell structure having a core 10a and a shell 10b covering the surface of the core 10a. As shown in FIG. 2B, many organic ligands 11 are preferably placed on the surface of the quantum dot 10. The core 10a of the quantum dot 10 shown in FIG. 2B is the nanoparticle shown in FIG. 2A. Accordingly, the core 10a is formed for example from the materials listed above. The shell 10b is formed from, for example, zinc sulfide (ZnS); however, the material of the shell 10b is not limited to this. As with the core 10a, the shell 10b is preferably free of cadmium (Cd).

The shell 10b may be in a condition of being a solid solution on the surface of the core 10a. In FIG. 2B, the boundary between the core 10a and the shell 10b is indicated by a dotted line, and this means that the boundary between the core 10a and the shell 10b may or may not be identified by an analysis.

### (Emitting layer 5)

The emitting layer 5 may be formed of the above-mentioned quantum dots 10 alone; alternatively, the emitting layer 5 may include the quantum dots 10 and another luminescent material other than the quantum dots. Further, since the emitting layer 5 can be formed by applying the quantum dots 10a dissolved in a solvent, the emitting layer 5 may contain some amount of the solvent component.

The quantum dots 10 contained in the emitting layer 5 include at least one type of quantum dots selected from blue quantum dots emitting blue light, red quantum dots emitting red light, and green quantum dots emitting green light. Further, the emitting layer 5 may contain a plurality of quantum dots 10 having different fluorescence wavelengths or may contain other luminescent materials in addition to the quantum dots 10.

As described above, the emitting layer 5 can be formed by applying (e.g., spin coating) the quantum dots 10 dissolved in a solvent or with the use of an inkjet printing process, a vacuum deposition process, or a conventional thin film formation method.

### (Hole transport layer 4)

The hole transport layer 4 is made of an inorganic material or an organic material having hole transporting functions. The hole transport layer 4 is preferably made of an inorganic material, for example, is preferably formed from an inorganic oxide such as NiO or WO₃. In particular, the hole transport layer 4 is preferably formed from nanoparticles of NiO. Further, for the hole transport layer 4, for example, Al₂O₃ or the like may be mixed in NiO. And, a metal oxide may be doped with Li, Mg, Al, etc. Further, the hole transport layer 4 may be formed from an inorganic material other than inorganic oxides.

As with the emitting layer 5, the hole transport layer 4 can be formed by applying a solvent containing nanoparticles by spin coating, may be formed by a printing process such as inkjet printing, or may be formed by the existing thin film technology such as vacuum deposition.

### (Electron transport layer 6)

The electron transport layer 6 is made of an inorganic material or an organic material having electron transporting functions. The electron transport layer 6 is preferably made of an inorganic material, for example, is preferably formed from an inorganic oxide such as ZnO₂, TiO₂, ZnO, SnO₂, V₂Oₓ, or MoO₃. Two or more of those materials may be selected as materials. In particular, the electron transport layer 6 is preferably formed from nanoparticles of ZnO. And, a metal oxide may be doped with Li, Mg, Al, Mn, etc. Further, the electron transport layer 6 may be of an inorganic material (for example, CsPbBr₃ etc.) other than inorganic oxides.

As with the emitting layer 5, the electron transport layer 6 can be formed by applying a solvent containing nanoparticles by spin coating, may be formed by a printing process such as inkjet printing, or may be formed by an existing thin film formation technique such as vacuum deposition.

### (Anode 3)

In this embodiment, for example, the anode 3 is preferably formed from a conductive transparent material such as an indium-tin oxide compound (ITO), a metal such as Au, CuISnO₂, or ZnO; however, the material of the anode 3 is not limited to those. Of those, the anode 3 is preferably formed from ITO. The anode 3 can be formed as a thin film of the electrode material on the substrate 2 by a method such as vapor deposition or sputtering.

The anode 3 needs to be a transparent electrode in a structure in which light is given off from the substrate 2 side, and is preferably formed from one of the metal oxides mentioned above or an extremely thin metal film.

### (Cathode 7)

In this embodiment, for example, a metal, an alloy, an electrically conductive compound, and a mixture of those can be used as an electrode material of the cathode 7; however, the material of the cathode 7 is not limited to those. Examples of the electrode material include Al, Mg, Li, and mixtures of those. Of those, the cathode 7 is preferably formed from Al.

The cathode can be formed as a thin film of the electrode material by a method such as vapor deposition or sputtering.

### (Substrate 2)

In this embodiment, the substrate 2 can be formed of, for example, glass or plastic; however, the material of the substrate 2 is not limited to these. The substrate 2 is preferably a transparent substrate in a structure in which light is given off from the substrate 2 side. Examples of the transparent substrate include, for example, glass, quartz, and transparent resin films.

The substrate 2 may either be a rigid substrate or a flexible substrate; when a flexible substrate is used, the light emitting device 1 can be made flexible. Examples of the material of the transparent film include, for example, polyethylene terephthalate (PET), polyethylene naphthalate (PEN), polyester, polyethylene, polypropylene, cellophane, cellulose diacetate, and cellulose triacetate (TAC).

In this embodiment, all the layers from the anode 3 to the cathode 7, that is, all the anode 3, the hole transport layer 4, the emitting layer 5, the electron transport layer 6, and the cathode 7 are preferably formed of an inorganic layer. Forming all the layers of inorganic layers allow all the layers to be formed using the same coating/drying apparatuses, etc. and facilitates the production process. Further, the high-low relationships of the HOMO levels of the anode 3, the hole transport layer 4, and the emitting layer 5 can be optimized. Further, the high-low relationships of the LUMO levels of the cathode 7, the electron transport layer 6, and the emitting layer 5 can be optimized. This improves the carrier balance as compared with the case of using organic compounds and renders a hole injection layer and an electron injection layer not essentially required. Thus, all the layers form the anode 3 to the cathode 7 are made of inorganic layers, so that the number of layers can be reduced. Note however that in this embodiment, a hole injection layer and an electron injection layer made of an inorganic material may be interposed between the electrodes and the transport layers.

In this embodiment, a layer between the anode 3 and the emitting layer 5 is preferably a hole transport layer 4, a hole injection layer, a layer serving as a hole injection layer and a hole transport layer, or a stack of a hole transport layer and a hole injection layer (in this case, the hole injection layer is formed on the anode 3 side, and the hole transport layer 4 is formed on the emitting layer 5 side).

In this embodiment, a layer between the cathode 7 and the emitting layer 5 is preferably an electron transport layer 6, an electron injection layer, a layer serving as an electron injection layer and an electron transport layer, or a stack of an electron transport layer and an electron injection layer (in this case, the electron injection layer is formed on the cathode 7 side, and the electron transport layer 4 is formed on the emitting layer 5 side).

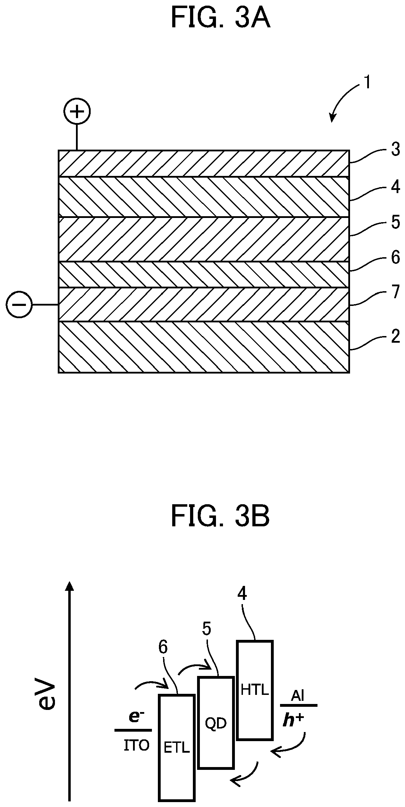

FIG. 3A is a cross-sectional view of an illumination device of Embodiment 2, and FIG. 3B is an energy level diagram of the illumination device of Embodiment 2.

The light emitting device 1 shown in FIG. 3A has an opposite layered structure to the structure in FIG. 1A. Namely, the cathode 7, the electron transport layer 6, the emitting layer 5, the hole transport layer 4, and the anode 3 are stacked in this order from the substrate 2 side. For the electron transport layer 6, the emitting layer 5, and the hole transport layer 4, the layers described above can be used. Further, the cathode 7 is preferably formed of for example ITO used for the anode 3 in FIG. 1A. This allows the cathode 7 that is an electrode on the substrate 2 side to be a transparent electrode, and allows light to be emitted from the substrate 2 side. Further, for the anode 3 shown in FIG. 3A, the material used for the cathode 7 shown in FIG. 1A, for example, Al can be used.

As described above, also in the light emitting device 1 depicted in FIG. 3A, the emitting layer 5 is formed of an inorganic layer containing quantum dots. Further, all the layers from the cathode 7 to the anode 3 are preferably formed of an inorganic layer. Note that the layered structure in FIG. 1 is preferred to the structure in FIG. 3 with respect to the balance of the energy level of the layers.

In this embodiment, the hole transport layer 4, the emitting layer 5, and the electron transport layer 6 can all be inorganic layers formed from nanoparticles. In such a case, each layer can be formed by application by spin coating or the like, thus the layers can be formed easily and formed to be uniform in thickness. This can effectively improve emission efficiency.

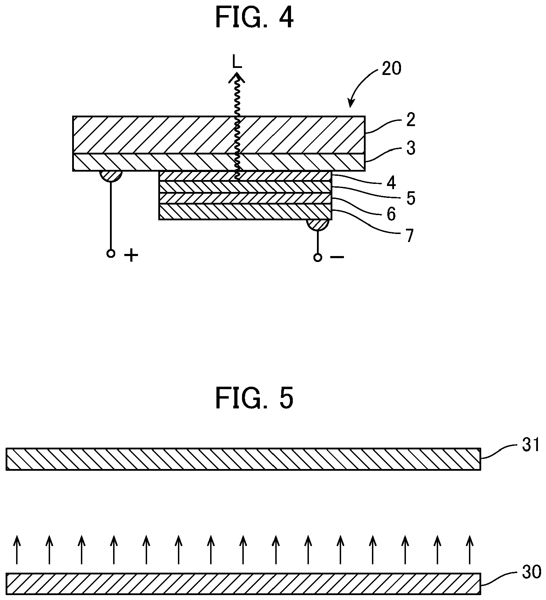

FIG. 4 is a cross-sectional view illustrating an example of an illumination device using the light emitting device shown in FIG. 1A. As shown in FIG. 4, the substrate 2 side is on the surface side, and the positive pole of the power source is connected to the anode 3 formed on the back surface of the substrate 2. Preferably, the layers from the hole transport layer 4 to the cathode 7 are for example, formed into a pattern having a shape smaller than the anode 3 so that the positive pole is easily connected to the anode 3. Further, the negative pole of the power source is connected to the cathode 7. In the illumination device 20 illustrated in FIG. 4, the substrate 2 is formed of a transparent glass substrate, and the positive pole 3 is formed from ITO; holes and electrons are recombined in the emitting layer 5, and light L from the excited quantum dots can be given off from the substrate 2 side.

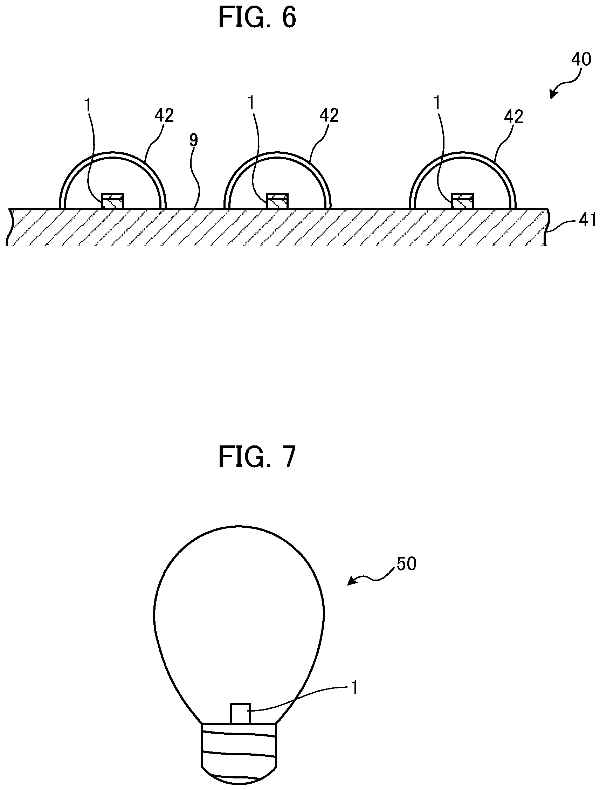

The illumination device 30 of this embodiment, depicted in FIG. 5 constitutes, for example, a back light unit placed on the back of a display device 31. The illumination device 30 shown in FIG. 5 is obtained by shaping the illumination device 20 depicted in FIG. 4 like a sheet. The illumination device 30 shown in FIG. 5 can perform surface light emission from the entire sheet surface. As illustrated in FIG. 5, the illumination device 30 is placed opposite to the display device 31 with a space therebetween, and light from the illumination device 30 can be directly applied to the display device 31. Alternatively, the illumination device as a light source 40 as illustrated in FIG. 6 can be used as a light source of the back light unit. In FIG. 6, a plurality of light emitting devices 1 according to this embodiment are placed on a support substrate 41, and the surface of each light emitting device 1 is covered with a dome-shaped lens portion 42. A light diffusing member (not shown) may be interposed between the light source 40 depicted in FIG. 6 and the display device 31.

Further, as illustrated in FIG. 7, the light emitting device 1 of this embodiment can constitute an electric light bulb 50 that is an illumination device using the light emitting device 1.

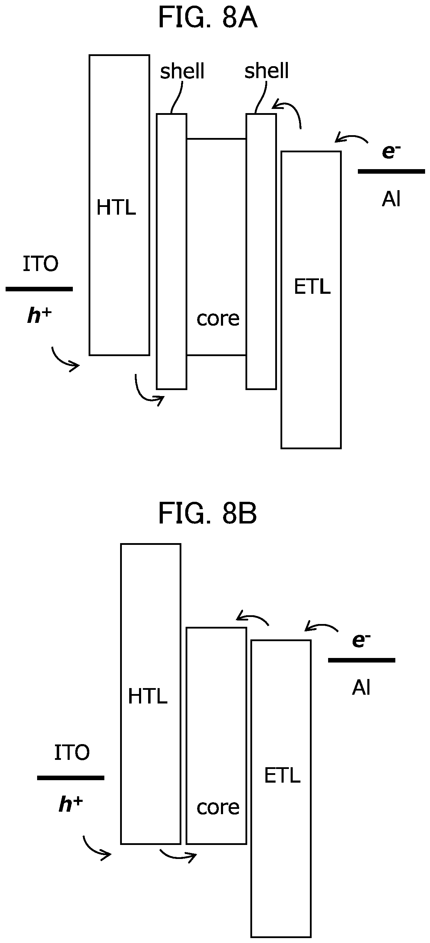

When the quantum dots used in the emitting layer 5 of this embodiment have a core-shell structure, the energy level diagram presented in FIG. 8A is obtained, and the energy level of the shell would serve as a barrier to the recombination of holes and electrons. Accordingly, a quantum dot of which surface is not covered with a shell (the surface of the core is exposed, or the material forming the quantum dot is uniform from the center of the quantum dot to the surface thereof) as shown in FIG. 8B is preferably used. This eliminates the energy barrier to the recombination of hole and electrons, and allows holes and electrons to be efficiently recombined, thus the light emission efficiency can be improved. With a view to improving the electron transportation efficiency and the hole transportation efficiency, the organic ligands 11 are preferably placed on the surface of each quantum dot 10 as illustrated in FIG. 2A.

Further, in a structure including quantum dots having core-shell structures of different fluorescence wavelengths in this embodiment, equating the energy levels of the shells of the quantum dots can appropriately facilitate the recombination. For this reason, the same material is preferably used for the shells used for the quantum dots.

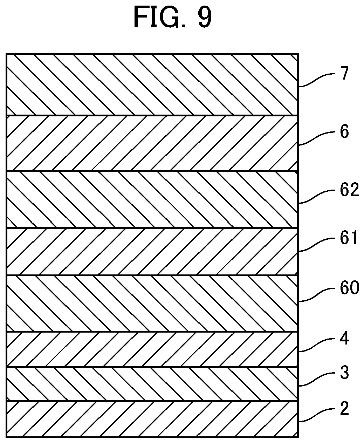

In order to obtain white light from an illumination device, three kinds of quantum dots: blue quantum dots, red quantum dots, and green quantum dots are necessarily used as the quantum dots used in the emitting layer. Here, the three kinds of quantum dots may be mixed in one emitting layer; alternatively, a blue quantum dot layer, a red quantum dot layer, and a green quantum dot layer may individually be prepared and stacked. For example, as illustrated in FIG. 9, the illumination device may have a structure in which a red quantum dot layer 60, a green quantum dot layer 61, and a blue quantum dot layer 62 are stacked. This allows the illumination device to emit white light.

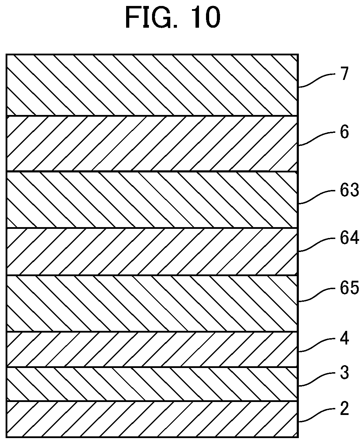

Alternatively, as illustrated in FIG. 10, the illumination device may have a layered structure (tandem structure) of a quantum dot layer 65 in which red quantum dots and green quantum dots are mixed, a blue quantum dot layer 63, and an interlayer 64 between the quantum dot layer 65 and the blue quantum dot layer 63. The interlayer 64 may have an intermediate electrode, or may be a laminate of A layer/intermediate electrode/B layer, A layer/intermediate electrode, or intermediate electrode/B layer. The A layer may be formed to have a layered structure of an electron transport layer, an electron injection layer, or a laminate of an electron injection layer and an electron transporting layer, whereas the B layer may be formed to have a layered structure of a hole transport layer, a hole injection layer, or a laminate of a hole injection layer and a hole transport layer.

As in this embodiment, using an illumination device using quantum dots, the quantum dots can be used to build either a point light source or a surface light source, and a curved light source or a flexible product may also be obtained by selecting a suitable substrate.

Further, according to this embodiment, distinctive products such as lightings producing a mixture of colors comparable to that of sunlight which has been hardly obtained, lightings producing light friendly to eyes, and lightings optimized for plant factories can be developed.

Thus, illumination devices using quantum dots provide a high degree of flexibility in the design; for example, the devices can be formed to be thin, lightweight, and curved. Further, the devices can produce natural light not dazzling in the eyes that produces less shadows. In addition, the devices consume less power and have a long life. For example, illumination devices using quantum dots of this embodiment are superior to organic EL lightings in terms of color rendering properties, emission properties, product life, and product price.

An illumination device using quantum dots of this embodiment can be used as a PL emitter as well as an EL emitter. Further, in an illumination device using quantum dots, a hybrid light emitting device in which an EL emitter and a PL emitter are stacked. For example, a PL emitter is superposed on a surface of an EL emitter, and the emission wavelength of the light emitted by excited quantum dots in the EL emitter can be changed using the quantum dots contained in the PL emitter. The EL emitter is a light emitting device having a layered structure described above, and the PL emitter is, for example, a sheet-like a wavelength converting member in which a plurality of quantum dots are dispersed in a resin. Such a hybrid structure can be obtained with the use of quantum dots.

Note that in this embodiment, in order to both increase the area of the illumination device using quantum dots and reduce the production cost, the inkjet printing process or the spin coating process, or the dispensing process is preferably used to apply the quantum dots.

### EXAMPLES

The effects of the present invention will be described using Examples of the present invention. Note that the embodiments of the present invention are not limited to the following examples in any way.

The samples shown in Table 1 below were prepared to investigate the drop characteristics in the inkjet process. Note that "Abs10" shown in Table 1 refers to a sample in which approximately 1 % by mass to 2 % by mass of quantum dots were added, and "Abs20" refers to a sample in which approximately 3 % by mass to 4 % by mass of quantum dots were added.

**[Table 1]**

| Sample | Solvent | SG | Viscosity (mPa·s) | R.T. (°C) | Ejection number | Mass (g) | Mass/drop (g) | Volume/drop (pL) | Drop | Adverse effect on EPDM | Notes |
|---|---|---|---|---|---|---|---|---|---|---|---|
| Green QD Abs10 | Cyclododecene | 0.87 | | 23.5 | 10 million | 0.0407 | 4.07E-09 | 4.68 | + | | |
| Red QD Abs20 | Cyclododecene | 0.87 | | 25.6 | 10 million | 0.0397 | 3.97E-09 | 4.56 | + | | |
| Red QD Abs20 | Tetradecane | 0.77 | | 26.1 | 10 million | 0.0303 | 3.03E-09 | 3.94 | + | Cap deformation | Head clogged |
| Green QD Abs10 | Tetradecane | | | | 10 million | Cancelled | | | + | | |
| Green QD Abs10 | Octadecene | 0.79 | 3.12 | 25.0 | 10 million | 0.0447 | 4.47E-09 | 5.66 | + | | |
| Red QD Abs20 | Octadecene | 0.79 | 2.97 | 26.7 | 10 million | 0.0449 | 4.49E-09 | 5.68 | + | | Previous head replacement |
| Polyvinylcarbazole | Dimethoxybenzene | 1.08 | | 26.7 | 10 million | 0.0579 | 5.79E-09 | 5.34 | + | Head replacement twice | Clogging after ethanol cleaning/ Clogging of damper filter |
| Polyvinylcarbazole | Dimethoxybenzene: Cyclohexylbenzene 1:1 | | | | | | | | - | Malformation of drops (2 drops) | |
| Polyvinylcarbazole | Dimethoxybenzene: Cyclohexylbenzene 2:1 | 1.13 | | 26.5 | 10 million | 0.0527 | 527E-09 | 4.66 | + | | |
| Zinc oxide nanoparticles | IPA:Propylene glycol 1:1 | | | | | | | | - | Defective drops Possibly highviscosity | |
| Solvent only | Tetradecane | 0.77 | 1.60 | 23.8 | 1 million | 0.0040 | 4.00E-09 | 4.60 | + | | |
| | Tetradecane | | | | 3 million | 0.0126 | 4.20E-09 | 4.83 | + | | |
| | Tetradecane | | | | | 0.0109 | 3.63E-09 | 4.18 | + | | |
| | Tetradecane | | | | 10 million | 0.0362 | 3.62E-09 | 4.16 | + | | |
| Solvent only | ODE(1-Octadecene) | 0.79 | 3.10 | 23.0 | 10 million | 0.0385 | 3.85E-09 | 4.87 | + | Cap deformation | |
| Solvent only | Decahydronaphthalene | 0.88 | 2.20 | 23.0 | 10 million | 0.0430 | 4.30E-09 | 4.89 | + | Affected | |
| Solvent only | Cyclododecene | 0.87 | 4.20 | 23.0 | 10 million | 0.0514 | 5.14E-09 | 5.91 | + | | |
| Solvent only | Ethylene glycol | 1.10 | 20.50 | 21.7 | Failed | - | - | - | - | Not affected | |
| Solvent only | Ethylene glycol 1 : IPA 1 | 0.94 | 7.40 | 25.0 | 10 million | 0.0500 | 5.00E-09 | 5.32 | + | Not affected | IPA specific gravity: 0.78 |
| Solvent only | Ethylene glycol 3 : IPA 1 | 1.02 | 12.80 | 22.7 | 10 million | 0.0481 | 4.81E-09 | 4.72 | + | Not affected | |
| Solvent only | Ethylene glycol 3 : IPA 2 | 0.97 | 10.30 | 22.3 | 10 million | 0.0500 | 5.00E-09 | 5.15 | + | Not affected | |
| Solvent only | Phenylcyclohexane | 0.94 | 2.29 | 26.3 | 10 million | 0.0444 | 4.44E-09 | 4.72 | + | | |
| Solvent only | Dichlorobenzene | 1.30 | 1.62 | 25.5 | Failed | - | - | - | - | Affected | |
| Solvent only | n-Octane | 0.70 | Unmeasurable | 24.3 | Failed | - | - | - | - | Cap deformation | |

The "+" signs shown in the "drop" column in Table 1 correspond to the samples that had been appropriately dropped and the "-" signs correspond to the samples that were failed to be appropriately dropped.

In Table 1, the samples of "Red QD" and "Green QD" are used in emitting layers. Further, the samples of "polyvinylcarbazole" are used in hole injection layers (hole injection layers). The sample of "Zinc oxide nanoparticles" is used in an electron transport layer or an electron injection layer.

Table 1 shows that IPA and propylene glycol were not preferred as the solvent for zinc oxide nanoparticles, and another solvent had to be used. The solvents corresponding to the "+" signs in the "drop" column shown in Table 1 can be appropriately used; especially, hydrophilic solvents are preferred. For example, as a hydrophilic solvent, an alcohol-based solvent can be used.

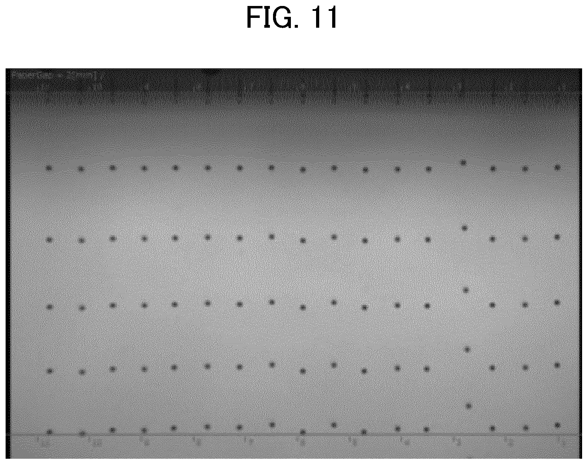

FIG. 11 is a photograph showing a state where the application was performed by the inkjet process using ZnO dissolved in ethoxyethanol:EG = 7:3 as a solvent. As shown in FIG. 11, a good application state was achieved.

Further, adverse effects on EPDM (ethylene propylene diene monomer rubber) inside the inkjet head was also investigated. As shown in Table 1, in some samples, cap deformation occurred or EPDM was adversely affected. This demonstrated that the effect on EPDM was preferably considered in the case of using EPDM.

### INDUSTRIAL APPLICABILITY

According to the present invention, a light emitting device can be used as an illumination device, and excellent emission properties can be obtained.

This application is based on Japanese patent application No. 2017-202874 filed on October 19, 2017, the content of which is hereby incorporated in its entirety.

## Claims

1. A light emitting device comprising an anode, an emitting layer, a cathode, a layer between the anode and the emitting layer, and a layer between the cathode and the emitting layer that are stacked,
wherein the emitting layer is formed of an inorganic layer containing quantum dots.

2. The light emitting device according to Claim 1, wherein all the layers from the anode to the cathode are each formed of the inorganic layer.

3. The light emitting device according to Claim 2, wherein the layer between the anode and the emitting layer, the emitting layer, and the layer between the cathode and the emitting layer are each constituted by the inorganic layer formed from nanoparticles.

4. The light emitting device according to any one of Claims 1 to 3, which is flexible.

5. The light emitting device according to any one of Claims 1 to 4, wherein the quantum dots have a structure in which a surface of a core is not covered by a shell.

6. The light emitting device according to any one of Claims 1 to 5, wherein the anode, the layer between the anode and the emitting layer, the emitting layer, the layer between the cathode and the emitting layer, and the cathode are stacked in this order on a substrate.

7. The light emitting device according to any one of Claims 1 to 5, wherein the cathode, the layer between the cathode and the emitting layer, the emitting layer, the layer between the anode and the emitting layer, and the anode are stacked in this order on a substrate.

8. An illumination device using the light emitting device according to any one of Claim 1 to Claim 7.
